# EUROPEAN PATENT APPLICATION

(11) **EP 4 443 256 A1**
(43) Date of publication of application: **09.10.2024**
(21) Application number: 24165557.0
(22) Date of filing: 22.03.2024
(51) Int. Cl.: G05B 19/418, H01L 21/67

(54) **CONTROLLING APPARATUS, SUBSTRATE PROCESSING APPARATUS, METHOD OF MANUFACTURING SEMICONDUCTOR DEVICE, AND PROGRAM**

(30) Priority: 07.04.2023 JP 2023063051
(71) Applicant: Kokusai Electric Corp., Tokyo 1010045 (JP)
(72) Inventor: QI, Yuanze, Toyama-shi, Toyama, 939-2393 (JP); MORI, Shinichiro, Toyama-shi, Toyama, 939-2393 (JP); KAWASAKI, Junichi, Toyama-shi, Toyama, 939-2393 (JP)
(74) Representative: Bardehle Pagenberg Partnerschaft mbB Patentanwälte Rechtsanwälte

(57) **Abstract**

There is provided a technique that includes: a recipe including a plurality of steps for which a processing condition for a substrate is defined; a display capable of displaying at least one selected from information on the plurality of steps included in the recipe and information on the processing condition of at least one step selected from the plurality of steps; an operator configured to perform an editing operation for the processing condition; and a controller capable of controlling information on a step for which the editing operation for the processing condition is performed to be displayed in a different manner from information on a step for which the editing operation is not performed.

## Description

### CROSS-REFERENCE TO RELATED APPLICATION

This application is based upon and claims the benefit of priority from Japanese Patent Application No. 2023-063051, filed on April 7, 2023, the entire contents of which are incorporated herein by reference.

### TECHNICAL FIELD

The present disclosure relates to a controlling apparatus, a substrate processing apparatus, a method of manufacturing a semiconductor device, and a program.

### BACKGROUND

In the related art, a substrate processing apparatus is described, which displays other recipes on the same screen when editing a specific recipe, thereby allowing for the creation of the specific recipe while referring to the contents of the other recipes.

In the technique disclosed in the related art, if settings that affect other steps are made when editing a selected step, switching between the steps is performed to check the settings. Therefore, this may lead to a decrease in operational efficiency during recipe-editing.

### SUMMARY

Some embodiments of the present disclosure provide a technique capable of achieving an improvement in operational efficiency during recipe-editing.

According to one embodiment of the present disclosure, there is provided a technique that includes: a recipe including a plurality of steps for which a processing condition for a substrate is defined; a display capable of displaying at least one selected from information on the plurality of steps included in the recipe and information on the processing condition of at least one step selected from the plurality of steps; an operator configured to perform an editing operation for the processing condition; and a controller capable of controlling information on a step, among the plurality of steps, for which the editing operation for the processing condition is performed to be displayed in a different manner from information on a step, among the plurality of steps, for which the editing operation is not performed.

### BRIEF DESCRIPTION OF DRAWINGS

The accompanying drawings, which are incorporated in and constitute a part of the specification, illustrate embodiments of the present disclosure.
FIG. 1 is a perspective view illustrating an example of a substrate processing apparatus according to an embodiment.
FIG. 2 is a cross-sectional view of the substrate processing apparatus according to the embodiment when viewed from the side.
FIG. 3 is a block diagram illustrating an example of a functional configuration of a controlling apparatus included in the substrate processing apparatus according to the embodiment.
FIG. 4 is a diagram illustrating an example of a recipe-editing screen according to the embodiment.
FIG. 5 is a diagram illustrating an example of icons displayed in a step-displaying area.
FIG. 6 is a sequence diagram illustrating an example of a process of displaying a temperature-editing icon, which is a first icon.
FIG. 7 is a sequence diagram illustrating an example of a process of displaying a jump icon, which is a second icon.
FIG. 8 is a sequence diagram illustrating an example of a process of displaying a loop icon, which is a third icon.
FIG. 9 is a sequence diagram illustrating an example of a process of hiding the temperature-editing icon when editing status information is invalid.

### DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

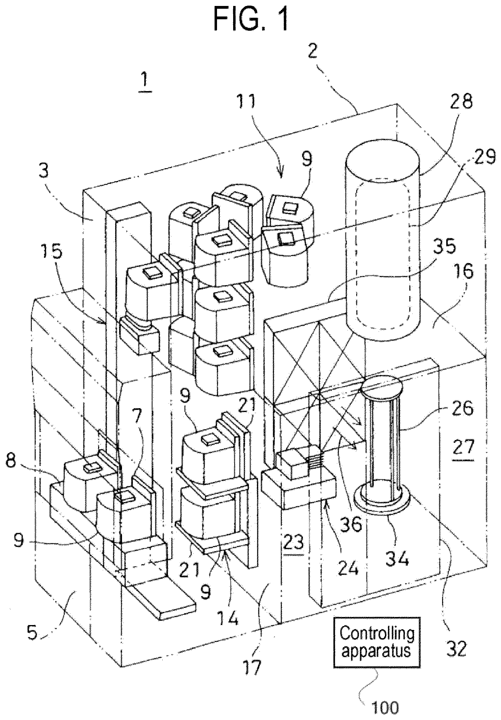

Hereinafter, one embodiment of the present disclosure will be described mainly with reference to FIGS. 1 to 9. In addition, the drawings used in the following description are all schematic, and a relationship between the dimensions of respective elements, the ratios of respective elements, etc. illustrated in the drawings do not necessarily correspond to the reality. Further, a relationship between the dimensions of respective elements, the ratios of respective elements, etc. may not necessarily correspond between multiple drawings. Further, the present disclosure is not limited to the following embodiments in any way, and modifications may be made within the scope of the present disclosure as appropriate.

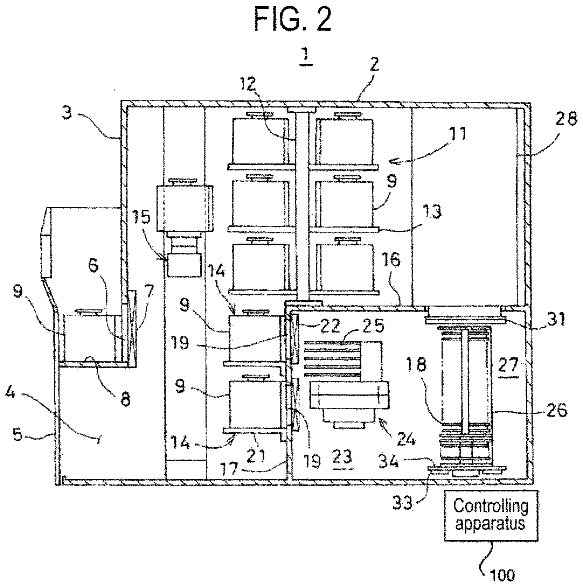

First, the outline of a controlling apparatus, a substrate processing apparatus, a method of manufacturing a semiconductor device, and a program according to the present embodiment will be described with reference to FIGS. 1 and 2.

FIG. 1 is a perspective view illustrating an example of a substrate processing apparatus 1 according to the present embodiment. Further, FIG. 2 is a cross-sectional view of the substrate processing apparatus 1 according to the present embodiment when viewed from the side. FIGS. 1 and 2 illustrate the vertical substrate processing apparatus 1 as an example of a substrate processing apparatus. In addition, a substrate processed in the substrate processing apparatus 1 is illustrated as an example of a semiconductor wafer made of silicon or the like.

As illustrated in FIGS. 1 and 2, the substrate processing apparatus 1 includes a housing 2, and a front maintenance port 4, which serves as a maintenance-friendly opening, is formed in a lower portion of a front wall 3 of the housing 2. The front maintenance port 4 is opened or closed by a front maintenance door 5.

A pod loading/unloading port 6 is formed in the front wall 3 of the housing 2 to allow communication between the inside and outside of the housing 2. The pod loading/unloading port 6 is opened or closed by a front shutter 7, which is a loading/unloading port opening/closing mechanism. A load port 8, which is a substrate transfer container delivery platform, is installed at the front side of the pod loading/unloading port 6. The load port 8 is configured to align a pod 9 placed thereon.

The pod 9 is a sealed substrate transfer container and is loaded onto or unloaded from the load port 8 by an in-process transfer device (not illustrated).

A rotary pod shelf 11, which is a substrate transfer container storage shelf, is installed in an upper region inside the housing 2 at the approximately center in the front-to-back direction. The rotary pod shelf 11 is configured to store a plurality of pods 9.

The rotary pod shelf 11 includes a pillar 12, which is vertically erected and intermittently rotates, and shelf plates 13, which serve as multi-level substrate transfer container placement plates, supported radially by the pillar 12 at upper, middle, and lower positions, respectively. The shelf plates 13 are configured to store at least one pod 9 placed thereon.

A pod opener 14, which serves as a substrate transfer container lid opening/closing mechanism, is provided below the rotary pod shelf 11. The pod opener 14 is configured to place the pod 9 thereon and to enable the opening or closing of a lid of the pod 9.

A pod transfer mechanism 15, which serves as a container transfer mechanism is installed between the load port 8, the rotary pod shelf 11, and the pod opener 14. The pod transfer mechanism 15 is configured to be vertically raised or lowered and horizontally advanced or retracted while holding the pod 9. The pod transfer mechanism 15 is configured to transfer the pod 9 between the load port 8, the rotary pod shelf 11, and the pod opener 14.

A sub-housing 16 is provided along the rear end in a lower region inside the housing 2 at the approximately center in the front-to-back direction. A pair of wafer loading/unloading ports 19, which serve as substrate loading/unloading ports for loading or unloading a wafer 18, which is a substrate, into or out of the sub-housing 16 are formed in a front wall 17 of the sub-housing 16 and are arranged at two upper and lower levels. The pod opener 14 is provided for each of the wafer loading/unloading ports 19 at the upper and lower levels.

The pod opener 14 includes a stage 21 for placing the pod 9 thereon and an opening/closing mechanism 22 for opening or closing the lid of the pod 9. The pod opener 14 is configured to open or close a wafer entrance/exit of the pod 9 by opening or closing the lid of the pod 9 placed on the stage 21 using the opening/closing mechanism 22.

The sub-housing 16 configures a transfer chamber 23, which is airtightly isolated from a space (pod transfer space) where the pod transfer mechanism 15 and the rotary pod shelf 11 are arranged. A wafer transfer mechanism 24, which serves as a substrate transfer mechanism, is installed in a front region of the transfer chamber 23. The wafer transfer mechanism 24 includes a required number (e.g., five in the illustration) of wafer placement plates 25 for placing the wafer 18 thereon. The wafer placement plates 25 are configured to be movable linearly in the horizontal direction, to be rotatable in the horizontal direction, or to be vertically raised or lowered. The wafer transfer mechanism 24 is configured to charge or discharge the wafer 18 into or out of a boat 26, which serves as a substrate holder.

A waiting section 27, where the boat 26 is accommodated in a waiting state, is configured in a rear region of the transfer chamber 23, and a vertical process furnace 28 is provided above the waiting section 27. The process furnace 28 defines a process chamber 29 in the interior thereof, and a lower end of the process chamber 29 forms a furnace opening. The furnace opening is opened or closed by a furnace opening shutter 31, which serves as a furnace opening/closing mechanism. In addition, the process chamber 29 is an example of a process container that processes a substrate.

A boat elevator 32, which serves as a substrate holder elevating mechanism for raising or lowering the boat 26, is installed between a right end of the housing 2 and a right end of the waiting section 27 in the sub-housing 16. A seal cap 34, which serves as a lid, is installed horizontally to an arm 33 connected to an elevating platform of the boat elevator 32. The seal cap 34 is configured to vertically support the boat 26 and to airtightly close the furnace opening when the boat 26 is charged into the process chamber 29.

The boat 26 is configured to hold a plurality of (e.g., 50 to 125) wafers 18 at multiple levels in a horizontal posture while aligning them around the center thereof. In addition, the notation of a numerical range such as "50 to 125" herein implies that the lower and upper limit values are included in that range. Thus, for example, "50 to 125" implies "50 or more and 125 or less". The same is applied to other numerical ranges.

A clean unit 35 is arranged at a position opposite to the boat elevator 32. The clean unit 35 is composed of a supply fan and a dust-proof filter to supply a purified atmosphere or inert gas such as clean air 36. For example, a nitrogen (N)-containing gas may be used as the inert gas. Examples of the N-containing gas may include a nitrogen (N₂) gas, ammonia (NH₃) gas, etc. One or more of these may be used as the N-containing gas. A notch aligner (not illustrated), which serves as a substrate alignment device for aligning the circumferential position of the wafer 18, is installed between the wafer transfer mechanism 24 and the clean unit 35.

The clean air 36 blown out from the clean unit 35 circulates through the notch aligner (not illustrated), the wafer transfer mechanism 24, and the boat 26, and is then sucked in by a duct (not illustrated), thereby being either discharged to the outside of the housing 2 or blown into the transfer chamber 23 by the clean unit 35.

Next, the operation of the substrate processing apparatus 1 will be described.

When the pod 9 is supplied to the load port 8, the pod loading/unloading port 6 is opened by the front shutter 7. The pod 9 on the load port 8 is loaded to the interior of the housing 2 through the pod loading/unloading port 6 by the pod transport mechanism 15 and is placed on the designated shelf plate 13 of the rotary pod shelf 11. After being temporarily stored on the rotary pod shelf 11, the pod 9 is transferred from the shelf plate 13 to either one of the pod opener 14 by the pod transfer mechanism 15, thereby being either placed on the stage 21, or transferred directly from the load port 8 to the stage 21.

At this time, each wafer loading/unloading port 19 is closed by the opening/closing mechanism 22, and the transfer chamber 23 is filled with the circulated clean air 36. For example, the transfer chamber 23 is filled with the N-containing gas as the clean air 36, so that the concentration of oxygen is set to, for example, 20 ppm or less, which is lower than the concentration of oxygen in the interior (atmospheric atmosphere) of the housing 2.

The end surface at the opening side of the pod 9 placed on the stage 21 is pressed against the opening edge of the wafer loading/unloading port 19 in the front wall 17 of the sub-housing 16, and the lid of the pod 9 is removed by the opening/closing mechanism 22 to open the wafer entrance/exit.

When the pod 9 is opened by the pod opener 14, the wafer 18 is retrieved from the pod 9 by the wafer transfer mechanism 24 and is then transferred to the notch aligner (not illustrated). After the wafer 18 is aligned in the notch aligner, the wafer transfer mechanism 24 loads the wafer 18 to the waiting section 27 in the rear region of the transfer chamber 23 to charge the wafer 18 into the boat 26.

After delivering the wafer 18 to the boat 26, the wafer transfer mechanism 24 returns to the pod 9 and charges the next wafer 18 into the boat 26.

While the wafer transfer mechanism 24 is charging the wafer 18 from the pod opener 14 at one side (either upper or lower level) into the boat 26, another pod 9 is transferred from the rotary pod shelf 11 to the pod opening 14 at the other side (either lower or upper level) by the pod transfer mechanism 15. Simultaneously, the pod 9 is opened by the pod opener 14 at the other side.

Once a predetermined number of wafers 18 have been charged into the boat 26, the furnace opening of the process furnace 28, which was closed by the furnace opening shutter 31, is opened by the furnace opening shutter 31. Subsequently, the boat 26 is raised by the boat elevator 32 and is loaded into the process chamber 29.

After loading, the furnace opening is airtightly closed by the seal cap 34. In addition, in the present embodiment, at this timing (after loading), the process chamber 29 undergoes a purge step (pre-purge step) in which it is replaced with an inert gas.

The process chamber 29 is evacuated by a gas exhaust mechanism (not illustrated) to reach a desired pressure (vacuum degree). Further, the process chamber 29 is heated to a predetermined temperature by a heater driver (not illustrated) to achieve desired temperature distribution.

Further, a process gas controlled at a predetermined flow rate is supplied by a gas supply mechanism (not illustrated). During the circulation of the process gas through the process chamber 29, the process gas comes into contact with a surface of the wafer 18, and a predetermined process is performed on the surface of the wafer 18. Furthermore, the reacted process gas is discharged from the process chamber 29 by the gas exhaust mechanism. The term "process gas" herein refers to a gas supplied into the process chamber 29. These are also the same in the following description.

After a preset process time has passed, an inert gas is supplied from an inert gas source (not illustrated) by the gas supply mechanism, so that the process chamber 29 is replaced with the inert gas, and the pressure in the process chamber 29 returns to normal pressure (after-purge step). Then, the boat 26 is lowered through the seal cap 34 by the boat elevator 32. The term "process time" herein refers to a time during which the process is continued. These are also the same in the following description.

For the unloading of the processed wafer 18, the reverse procedure of the above description is followed to discharge the wafer 18 and the pod 9 to the outside of the housing 2. Unprocessed wafers 18 are also charged into boat 26, and the batch process of wafers 18 is repeated.

Here, as illustrated in FIGS. 1 and 2, the substrate processing apparatus 1 includes a controlling apparatus 100, and the controlling apparatus 100 controls the substrate processing apparatus 1. The controlling apparatus 100 may be built into the substrate processing apparatus 1, or may be provided in an accessible manner outside the substrate processing apparatus 1. The substrate processing apparatus 1 is an example of a target apparatus. In the following, a case where the controlling apparatus 100 according to the present embodiment is applied to the substrate processing apparatus 1 will be described, but the controlling apparatus 100 may control apparatuses other than the substrate processing apparatus 1.

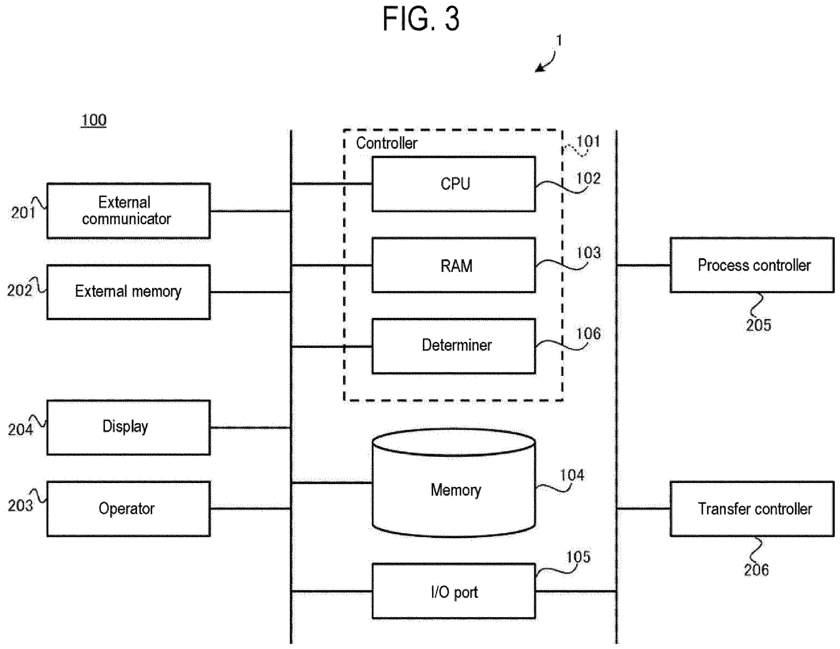

Next, a configuration of a control system of the substrate processing apparatus 1 according to the present embodiment will be described with reference to FIG. 3.

FIG. 3 is a block diagram illustrating an example of a functional configuration of the controlling apparatus 100 included in the substrate processing apparatus 1 according to the embodiment.

As illustrated in FIG. 3, the substrate processing apparatus 1 includes the controlling apparatus 100 as a main controller, an external communicator 201, an external memory 202, an operator 203, a display 204, a process controller 205, and a transfer controller 206. The controlling apparatus 100 contains a recipe having a plurality of steps for which substrate processing conditions are defined.

Further, the controlling apparatus 100 includes a controller 101, a memory 104, and an I/O (also referred to as an I/O port) 105. The controller 101 includes a central processing unit (CPU) 102, a random access memory (RAM) 103, and a determiner 106.

The controlling apparatus 100 is connected to the operator 203 and is also connected to the process controller 205 and the transfer controller 206 via the I/O 105. Since the controlling apparatus 100 is electrically connected to each of the process controller 205 and the transfer controller 206 via the I/O 105, it allows for the transmission and reception of each datum as well as the downloading and uploading of each file.

The controlling apparatus 100 is connected to an external host computer (not illustrated) via the external communicator 201. Therefore, even if the substrate processing apparatus 1 is installed in a clean room, the host computer may be located outside the clean room such as in an office. Further, the controlling apparatus 100 is connected to the external memory 202, which serves as a mount into which a recording medium such as a universal serial bus (USB) memory is detachably inserted.

The operator 203 is integrated with the display 204, or is connected to the display 204 through, e.g., a video cable. The display 204 is, for example, a liquid crystal display panel. The display 204 is configured to display each operation screen for operating the substrate processing apparatus 1. The operation screen includes a screen for monitoring the state of a substrate process system controlled by the process controller 205 and a substrate transfer system controlled by the transfer controller 206. The display 204 may further include an input element such as each operation button to input operational instructions for the substrate process system and the substrate transfer system. The operator 203 enables the display 204 to display information generated in the substrate processing apparatus 1 through the operation screen. Further, the operator 203 enables, for example, the output of the information displayed on the display 204 to a device such as a USB memory inserted into the external memory 202. The operator 203 receives input data (input instructions) from the operation screen displayed on the display 204 and transmits the input data to the controlling apparatus 100. Further, the operator 203 receives instructions (control instructions) to execute an arbitrary substrate process recipe (also referred to as "process recipe") among a plurality of recipes developed in the RAM 103 or stored in the memory 104 and transmits the instructions to the controlling apparatus 100. In addition, the operator 203 and the display 204 may be configured with a touch panel. Here, the operator 203 and the display 204 are provided separately from the controlling apparatus 100, but may be integrally included in the controlling apparatus 100.

The process controller 205, although not illustrated here, includes at least one of a temperature controller, a gas flow-rate controller, and a pressure controller. Each of the temperature controller, the gas flow-rate controller, and the pressure controller constitutes a sub-controller and is electrically connected to the process controller 205, enabling the transmission and reception of each datum, the downloading and uploading of each file, etc. In addition, the process controller 205 and each sub-controller (temperature controller, gas flow-rate controller, and pressure controller) may be configured separately or as an integrated component.

The transfer controller 206, although not illustrated here, includes a mechanism controller. This mechanism controller is configured to control each of a driver system, a rotator system, and an elevator system of the substrate processing apparatus 1. The transfer controller 206 is configured to control, for example, the transfer operation of each of the rotary pod shelf 11, boat elevator 32, pod transfer mechanism 15, wafer transfer mechanism 24, boat 26, and rotation mechanism (not illustrated).

In addition, the controlling apparatus 100, process controller 205, and transfer controller 206 according to the present embodiment are not limited to a dedicated system and may be realized using a conventional computer system. For example, each controller that executes a predetermined process may be configured by installing a program for executing the above-described process from a recording medium (such as CD-ROM or USB) storing that program to a general-purpose computer.

Then, there is an arbitrary way for supplying these programs. The programs may be supplied through a predetermined recording medium as described above, or alternatively, may be supplied through, for example, communication lines, communication networks, communication systems, etc.

The controlling apparatus 100 is configured as a computer equipped with the CPU 102, RAM 103, memory 104, I/O 105, and determiner 106. The memory 104 stores each recipe file for recipes in which processing conditions and process procedures are defined, a control program file for executing each recipe file, a parameter file (setting value file) for setting the processing conditions and process procedures, an error-processing program file, an error-processing parameter file, a file for various screens including an input screen for inputting process parameters, a file for various icons, etc. (none of which are illustrated). In addition, the controlling apparatus 100 is connected to a network such as the Internet, local area network (LAN), or wide area network (WAN) using the external communicator 201, thus enabling communication with external devices through the network.

Each recipe file, such as a recipe, may be acquired from another device through the external communicator 201, or may be acquired from a recording medium such as a USB through the external memory 202.

Further, for example, a hard disk drive (HDD), solid state drive (SSD), and flash memory, etc. are used as the memory 104.

The memory 104 stores a display switching process program for executing a display switching process according to the present embodiment. The display switching process is control to switch a step selected in a step-displaying area, which will be described later, to be displayed in a different manner compared to other steps when an editing operation for processing conditions is performed. The display switching process may be interpreted as a control to differentiate the display of an icon for a step for which an editing operation is performed from the display of an icon for a step for which the editing operation is not performed, when the editing operation for processing conditions is performed.

The display switching process program may be installed in advance in the substrate processing apparatus 1, for example. The display switching process program may be realized by recording it on a non-volatile recording medium, or distributing it through a network, and appropriately installing it in the substrate processing apparatus 1. In addition, examples of the non-volatile recording medium include a CD-ROM, magneto-optical disk, HDD, DVD-ROM, flash memory, memory card, USB, etc.

The display switching process program may be interpreted as a program for causing the computer to execute first, second, and third procedures. The first procedure involves displaying at least one of a step-displaying area that displays a plurality of steps included in a recipe, for which processing conditions for a substrate are defined, and a processing-condition-displaying area that displays the processing conditions of the steps on a screen. The second procedure involves performing an editing operation for the processing conditions of a step selected in the step-displaying area. The third procedure involves controlling to switch the step selected in the step-displaying area to be displayed in a different manner compared to other steps that the editing operation is not performed when the editing operation for the processing conditions is performed.

The CPU 102 of the substrate processing apparatus 1 according to the present embodiment functions as the controller 101 by writing the display switching process program stored in the memory 104 into the RAM 103 and executing it.

The display 204 is capable of displaying at least one of information on the plurality of steps included in the recipe, for which the substrate processing conditions are defined, and information on the processing conditions of the selected step. Specifically, the display 204 displays a recipe-editing area on a screen, i.e., a recipe-editing screen, and the recipe-editing area is capable of displaying at least one of the step-displaying area that displays the plurality of steps of the recipe and the processing-condition-displaying area that displays the processing conditions of the steps. Display examples of the step-displaying area and processing-condition-displaying area will be described later.

The operator 203 performs the editing operation for the processing conditions. Specifically, the operator 203 performs the editing operation for the processing conditions of the step selected in the step-displaying area.

The controller 101 is capable of controlling information on a step for which the editing operation for the processing conditions is performed to be displayed in a different manner compared to information on other steps that the editing operation is not performed. Specifically, when the editing operation for the processing conditions is performed, the controller 101 is capable of controlling to switch the step selected in the step-displaying area to be displayed in a different manner compared to other steps that the editing operation is not performed.

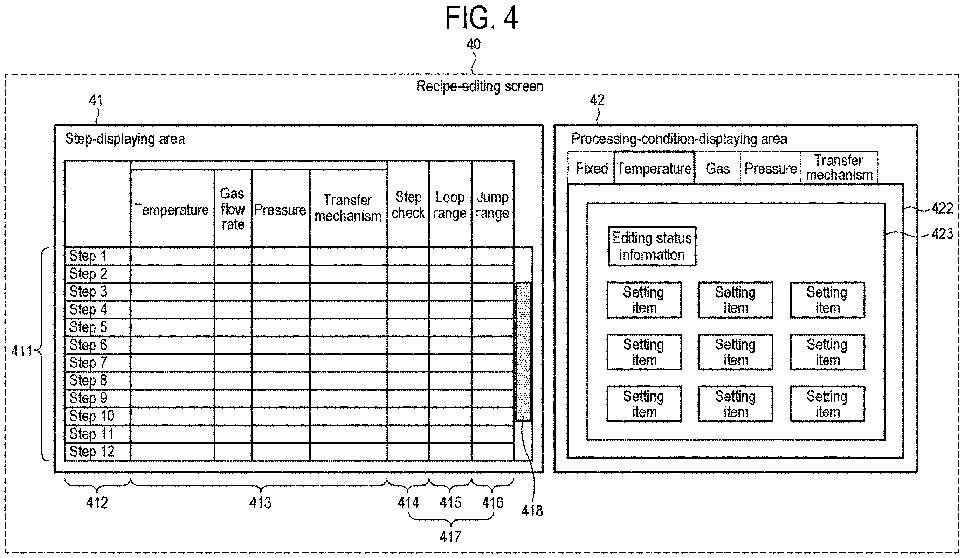

FIG. 4 is a front view illustrating an example of a recipe-editing screen 40 according to the present embodiment. The display 204 displays the recipe-editing screen 40 illustrated in FIG. 4 under the control of the controller 101. The recipe-editing screen 40 includes a step-displaying area 41 and a processing-condition-displaying area 42. The display 204 is capable of displaying the step-displaying area 41 and the processing-condition-displaying area 42 side by side on the recipe-editing screen 40. Displaying the step-displaying area 41 and the processing-condition-displaying area 42 side by side on the recipe-editing screen 40 allows to check the editing state of the step selected in the step-displaying area 41 while also checking the editing state of other steps. Further, if the step-displaying area 41 and the processing-condition-displaying area 42 are displayed to overlap each other, switching between the respective displaying areas occurs. However, displaying the respective displaying areas side by side enables to make detailed settings while checking the state of each step.

### (Step-displaying area 41)

The step-displaying area 41 displays the plurality of steps included in the recipe in order in which the steps are defined. The step-displaying area 41 may be interpreted as an area that lists the plurality of steps included in the recipe.

The step-displaying area 41 includes a multi-step information area 411 and a scroll bar 418. The multi-step information area 411 includes a step-name-displaying area 412, a setting-item-displaying area 413, a consistency-determination-result-displaying area 414, a loop-information-displaying area 415, and a jump-information-displaying area 416. The jump-information-displaying area 416 and loop-information-displaying area 415 are included in a step-execution-condition-displaying area 417.

The step-name-displaying area 412 displays a name indicating each step in the step-displaying area 41, for example, a step ID.

The setting-item-displaying area 413 displays the editing state of the steps. Specifically, when the editing operation for the processing conditions including setting items is performed in the processing-condition-displaying area 42, the setting-item-displaying area 413 displays a step selected in the step-displaying area 41 to be displayed in a different manner compared to other steps that the editing operation is not performed. The displaying the step selected in the step-displaying area 41 involves a first icon indicating that the editing operation is performed. By differentiating the display modes of the step for which the editing operation is performed and other steps that the editing operation is not performed in the step-displaying area 41, it becomes easier to check the step for which the editing operation is performed, which results in an improvement in editing workability.

When the setting items are edited in the processing-condition-displaying area 42, the "editing status information" in the processing-condition-displaying area 42 becomes valid. The "editing status information" in the processing-condition-displaying area 42 is checked for the setting items within the step selected in the step-displaying area 41, and if the "editing status information" is valid, the first icon is displayed. In this way, the immediate display of the first icon in the step-displaying area 41 when the setting items are edited allows for the recognition of the current step undergoing the editing operation.

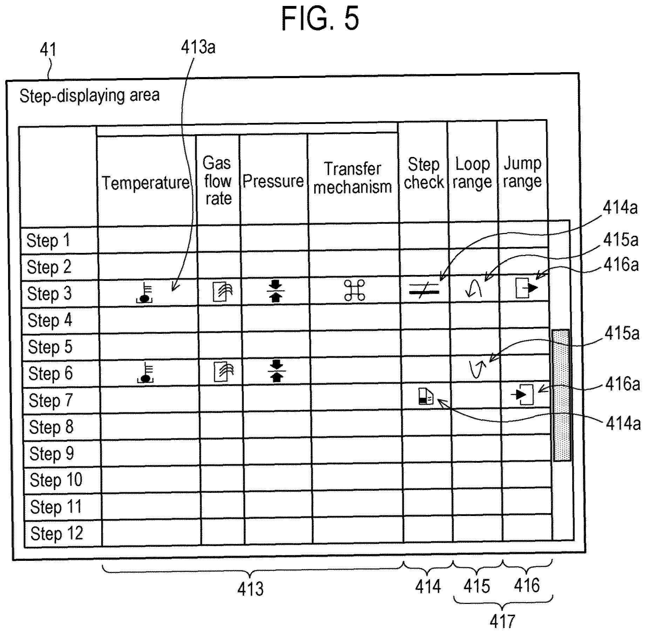

FIG. 5 is a diagram illustrating an example of icons displayed in the step-displaying area 41. The processing conditions include at least one of the following setting items: temperature, gas flow rate, pressure, and transfer mechanism as types of setting items, and the operator 203 is capable of performing an editing operation for these setting items.

In the present embodiment, for example, the setting items within each step include various types of setting items such as temperature, gas flow rate, pressure, and transfer mechanism as types of setting items. There are many setting items within each step, and the processing-condition-displaying area 42 illustrated in FIG. 4 allows for an editing operation for the setting items such as temperature, gas flow rate, pressure, and transfer mechanism as types of setting items by switching between the respective types using different regions (e.g., layers, tabs, etc.).

In this way, the setting-item-displaying area 413 of the step-displaying area 41 includes areas that display editing icons for each type of the setting items such as temperature, gas flow rate, pressure, and transfer mechanism as types of setting items. If a setting item within the selected step is edited, the step-displaying area 41 displays an editing icon, e.g., a first icon 413a, only for the edited setting item. For example, if an editing operation for temperature is performed in Step 3, an editing icon corresponding to the temperature, e.g., a temperature-editing icon is displayed only in the edited temperature area of the setting-item-displaying area 413 of the step-displaying area 41. Dividing the setting-item-displaying area 413 for each type of the setting items allows to easily check the edited type of the setting item within that step.

Similarly, if an editing operation for gas flow rate is performed in Step 3, an editing icon corresponding to the gas flow rate is displayed only in the edited gas flow rate area. If an editing operation for pressure is performed in Step 3, an editing icon corresponding to the pressure is displayed only in the edited pressure area. Further, if an editing operation for transfer mechanism is performed in Step 3, an editing icon corresponding to the transfer mechanism is displayed only in the edited transfer mechanism area.

As illustrated in FIG. 5, the editing icons, which are displayed when each of temperature, gas flow rate, pressure, and transfer mechanism as types of setting items is edited, may be displayed in different designs, i.e., displayed in a different manner for each type. Differentiating the editing icons, e.g., the first icons 413a for each setting item allows to visually recognize the edited type without checking which of temperature, gas flow rate, pressure, and transfer mechanism as types of setting items is edited.

In addition, if the operator 203 cancels the editing operation for the setting item, the editing icon, i.e., the first icon 413a, may be hidden. Specifically, for example, if the editing operation for temperature is edited, the editing icon corresponding to the temperature within that step in the step-displaying area 41 may be hidden by pressing a "editing status information" button in the processing-condition-displaying area 42, i.e., setting it to OFF (graying it out). If the "editing status information" in the processing-condition-displaying area 42 is set to OFF as such, the "editing status information" for the step selected in the step-displaying area 41 is checked, and if the "editing status information" is invalid, the first icon 413a is hidden. Setting the "editing status information" to OFF cancels all the edited setting items, which allows the step to revert to the previous contents thereof.

The processing-condition-displaying area 42 allows the operator 203 to set commands (not illustrated), which are execution conditions for the selected step. The step-displaying area 41 includes the step-execution-condition-displaying area 417 that displays the step execution conditions set in the processing-condition-displaying area 42. The step-execution-condition-displaying area 417 includes at least one of the jump-information-displaying area 416 that displays a jump icon, i.e., jump information indicating transition from the selected step to another step, and the loop-information-displaying area 415 that displays a loop icon, i.e., loop information indicating repetition of each step between the selected step and a specified step. Providing the jump-information-displaying area 416 and the loop-information-displaying area 415 in the step-execution-condition-displaying area 417 allows for the recognition of the step state of a jump source and jump destination and the step state of a loop start and loop end. Steps have a function to execute specified commands such as a jump command to transition to a specified step and a loop command to repeat a cycle between the current step being edited and a specified step. Further, sub-recipes (not illustrated) may be invoked, and settings that specify no command may be made. Only one command among these commands may be selected.

If a command, e.g., a jump command is selected and a step for the jump destination is specified in the processing-condition-displaying area 42, the display 204 switches a step where a jump starts, i.e., a jump start step and a step where the jump ends, i.e., a jump end step to be displayed in a different manner compared to other steps in the jump-information-displaying area 416. Specifically, if a jump is specified as a step command, a screen for selecting a step for the jump destination is displayed. If the jump destination step is selected from the screen, the display 204 sets the current step selected in the step-displaying area 41 to the jump start step, i.e., a jump source step, and the specified jump destination step to the jump end step. Then, the display 204 differentiates the display of each set step from the display of steps where no jump is specified. Differentiating the display of the jump start and end steps from that of steps where no jump is specified allows to easily check the jump step and end steps.

The display 204 displays, as second icons 416a, an icon indicating the jump start step, i.e., a jump start icon, and an icon indicating the jump end step, i.e., a jump end icon, the jump start icon and the jump end icon being different from each other. Specifically, the display 204 displays the second icons 416a, which are jump icons different from the editing icons, for the jump start step and the jump end step. The second icons 416a displayed for the jump start step and the jump end step are displayed in a different manner, respectively. For example, the second icon 416a with the mode corresponding to the jump start step is displayed in the jump-information-displaying area 416 for Step 3. The second icon 416a with the mode corresponding to the jump end step is displayed in the jump-information-displaying area 416 for Step 7. Differentiating the display of the second icons 416a allows to easily distinguish the jump start and end steps.

The step-displaying area 41 includes the jump-information-displaying area 416 that displays the jump icons (jump start icon and jump end icon), which are the second icons 416a, and the setting-item-displaying area 413 that displays the setting items. The jump icons, which are the second icons 416a, are displayed differently from the editing icons displayed in the setting-item-displaying area 413. Differentiating the display mode of the second icons 416a, which correspond respectively to the jump start and end steps, from the display mode of the first icons 413a in the setting-item-displaying area 413 ensures that each setting information is clearly distinguished.

When a command, e.g., a loop command is selected and a step for the loop destination is specified in the processing-condition-displaying area 42, the display 204 switches a step where a loop starts, i.e., a loop start step and a step where the loop ends, i.e., a loop end step to be displayed in a different manner compared to other steps in the loop-information-displaying area 415. Specifically, if a loop is specified as a step command, a screen for selecting a step for the loop destination step displayed. If the loop destination step is selected from the screen, the display 204 sets the current step selected in the step-displaying area 41 to the loop start step and the specified loop destination step to the loop end step and differentiates the display of each set step from the display of steps where no loop is specified. Differently displaying the loop start and end steps from steps where no loop is specified allows to easily check the loop start and end steps.

The display 204 displays, as third icons 415a, an icon indicating the loop start step, i.e., a loop start icon, and an icon indicating the loop end step, i.e., a loop end icon, the loop start icon and the loop end icon being different from each other. Specifically, the display 204 displays the third icons 415a, which are loop icons different from the first and second icons 413a and 416a, for the loop start step and the loop end step. Further, the third icons 415a displayed for the loop start step and the loop end step are displayed in a different manner, respectively. The third icon 415a corresponding to the loop start step is displayed in the loop-information-displaying area 415 for Step 6 illustrated in FIG. 5, and the third icon 415a corresponding to the loop end step is displayed in the loop-information-displaying area 415 for Step 3. Differentiating the display of the third icons 415a for the loop start step and the loop end step allows to easily distinguish the loop start and end steps.

The step-displaying area 41 includes the loop-information-displaying area 415 that displays the loop icons, which are the third icons 415a, and the setting-item-displaying area 413 that displays the setting items. The loop icons, which are the third icons 415a, are displayed differently from the editing icons displayed in the setting-item-displaying area 413. Differentiating the display mode of the third icons 415a, which correspond respectively to the loop start step and loop end step, from the display mode of the first icons 413a in the setting-item-displaying area 413 ensures that each setting information is clearly distinguished.

The controller 101 includes a determiner 106 that determines the consistency of steps. The determiner 106 determines at least one of the consistency within a step for which is edited for the processing conditions and the consistency with steps before and after the edited step.

The consistency determination by the determiner 106 includes two types of determinations. A first determination includes consistency determination for each setting item within the step, consistency determination for jump setting, and consistency determination for loop setting. The consistency determination for each setting item within the step involves checking whether a set value of the setting item falls within a predefined threshold range. The consistency determination for jump setting involves checking whether the jump destination step is specified as a step after the current step being edited. The consistency determination for loop setting involves checking whether the loop setting (double loop) is not in loop designation and whether the loop destination step is specified as a step before the current step being edited. If the result of these consistency determinations is mismatch, each icon in each area is switched to an icon indicating an error. Performing the consistency determination within the step may avoid the setting of an incorrect value. Performing the consistency determination for jump setting may avoid an infinite step jump due to an incorrectly specified step. Performing the consistency determination for loop setting may avoid an unnecessary loop or incorrect loop.

A second determination involves determining differences in the editing contents of the setting-item-displaying area 413 between the start step and the end step when specifying the jump or loop. For example, if the editing icon displayed in the setting-item-displaying area 413 for the jump start step differs from the editing icon displayed in the setting-item-displaying area 413 for the jump end step, it visually indicates that the jump start step and the jump end step have different editing contents. However, it cannot necessarily be considered an error since such a setting may be made intentionally in recipe setting.

If the result determined by the determiner 106 is mismatch, the controller 101 controls the display 204 to display a determination result icon, which is a fourth icon 414a, according to the result determined by the determiner 106. Since the result of the second consistency determination requires the worker's confirmation, the controller 101 displays, in the step-displaying area 41, the determination result icon, i.e., the fourth icon 414a displayed in a different manner from the first to third icons 413a, 416a, and 415a. This allows for the easy recognition of steps that require the confirmation.

The step-displaying area 41 includes the consistency-determination-result-displaying area 414 that displays the result determined by the determiner 106, and the determination result icon, i.e., the fourth icon 414a, is displayed in the consistency-determination-result-displaying area 414. Specifically, the step-displaying area 41 includes the consistency-determination-result-displaying area 414 that displays the determination result icon, which is the fourth icon 414a. Steps where the fourth icon 414a is displayed may have different values of the setting items even if the edited type is the same. Therefore, in this case, the fourth icon 414a is displayed in a different manner in the consistency-determination-result-displaying area 414.

For example, if the setting items are the same for Step 3 as the loop start step and Step 6 as the loop end step, but there are differences in the detailed setting contents, the fourth icon 414a prompting the checking of the setting contents is displayed in the consistency-determination-result-displaying area 414 for Step 3. Further, if the contents of the edited setting items are different between Step 7 as the jump start step and Step 3 as the jump end step, the fourth icon 414a indicating that the contents of the setting items are different is displayed in the consistency-determination-result-displaying area 414 for Step 7.

In this way, by displaying the fourth icon 414a, which is the determination result icon, in a different area from the areas where the first to third icons 413a, 416a, and 415a are displayed, it is possible to easily check steps where the fourth icon 414a is displayed.

In addition, the shapes of the icons as described in the present embodiment are not limited to this, as long as it is possible to easily check whether or not editing is performed for each setting item, or the start and end of a jump and the start and end of a loop.

### (Processing-condition-displaying area 42)

The processing-condition-displaying area 42 illustrated in FIG. 4 includes a process-condition-setting area 422 and a setting-item-editing area 423 for each setting item. FIG. 4 illustrates, as an example, a temperature process-condition-setting area and a temperature information setting-item-editing area, which are respectively the process-condition-setting area 422 and the setting-item-editing area 423 when temperature is selected as the setting item. The temperature information setting-item-editing area displays editing status information and a plurality of setting items.

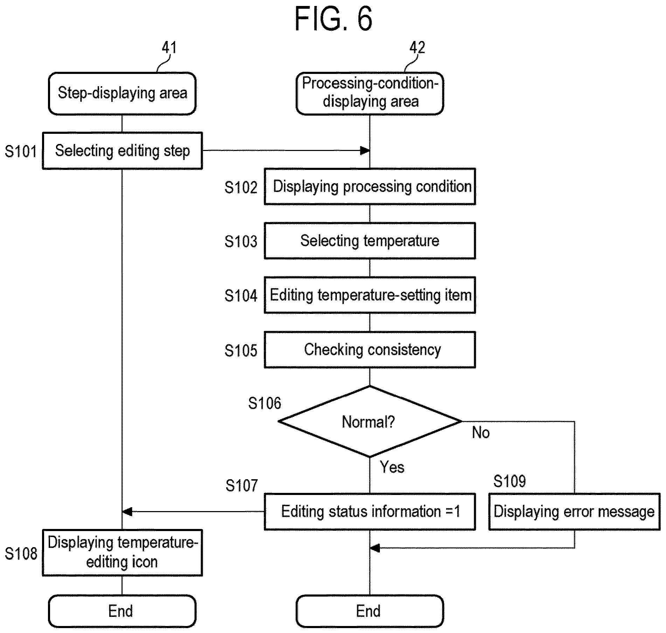

Next, the operation of the controlling apparatus 100 will be described with reference to FIGS. 6 to 9.

FIG. 6 is a sequence diagram illustrating an example of a process of displaying a temperature-editing icon, which is the first icon. If an editing target step is selected in the step-displaying area 41 (step S101), processing conditions are displayed in the processing-condition-displaying area 42 (step S102).

If a temperature tab of the processing-condition-displaying area 42 is selected (step S 103), a temperature-setting item is displayed in the setting-item-editing area 423 corresponding to the temperature. If the setting item is edited (step S104), the consistency of the temperature-setting item is checked (step S105).

If the result of the consistency checking is normal (step S106: "YES"), "1" indicating that the editing status information is valid is set (step S107). In this case, a temperature-editing icon is displayed in the step-displaying area 41 (step S 108), and the series of process ends.

If the result of the consistency checking is not normal (step S106: "NO"), an error message indicating that the result of the consistency checking is not normal is displayed in the processing-condition-displaying area 42 (step S109). In this case, a temperature-editing icon is not displayed in the step-displaying area 41, and the series of process ends.

The error message may be displayed at any position in the processing-condition-displaying area 42, and further, an abnormal item may be displayed differently from other items.

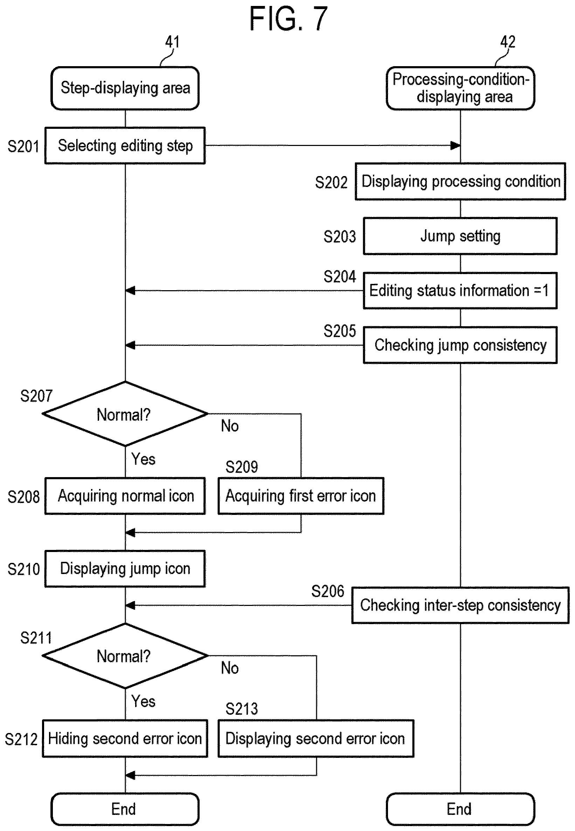

FIG. 7 is a sequence diagram illustrating an example of a process of displaying a jump icon, which is the second icon. If an editing target step is selected in the step-displaying area 41 (step S201), processing conditions are displayed in the processing-condition-displaying area 42 (step S202).

If a jump command is set in the processing-condition-displaying area 42 (step S203) and "1" indicating that the editing status information is valid is set (step S204), the consistency for jump setting is checked (step S205). Further, following the checking of the consistency for jump setting, the inter-step consistency is checked (step S206).

If the checked result of the consistency for jump setting is normal (step S207: "YES"), an icon indicating that the jump setting is normal is acquired (step S208). If the checked result of the checking for jump setting is not normal (step S207: "NO"), an icon (first error icon) indicating that the jump setting is abnormal is acquired (step S209). After that, the jump icons acquired respectively in steps S208 and S209 are displayed in the jump-information-displaying area 416 (step S210).

If the checked result of the inter-step consistency is normal (step S211: "YES") and an icon (second error icon) indicating that inter-step setting is abnormal is displayed, the icon is hidden in the consistency-determination-result-displaying area 414 (step S212), and the series of process ends.

If the checked result of the inter-step consistency is not normal (step S211: "NO"), the icon (second error icon) indicating that the inter-step setting is abnormal is displayed in the consistency-determination-result-displaying area 414 (step S213), and the series of process ends.

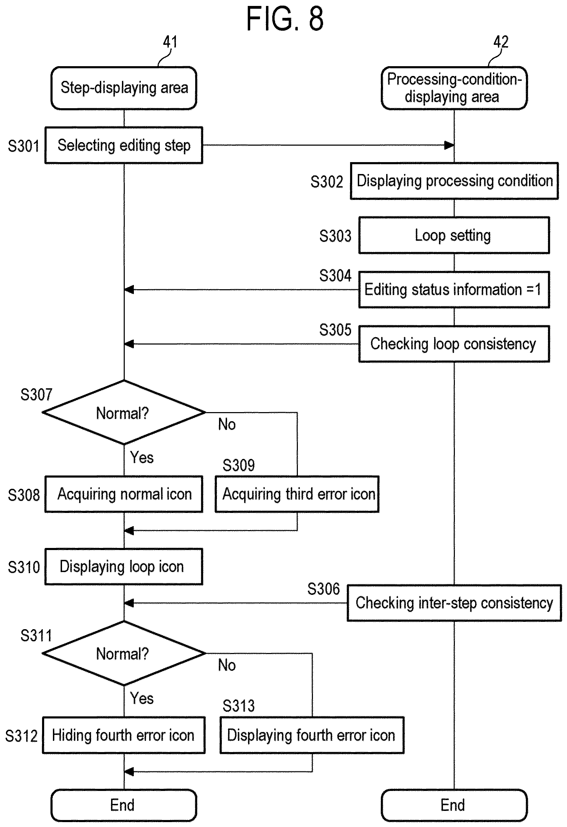

FIG. 8 is a sequence diagram illustrating an example of a process of displaying a loop icon, which is the third icon. If an editing target step is selected in the step-displaying area 41 (step S301), processing conditions are displayed in the processing-condition-displaying area 42 (step S302).

If a loop command is set in the processing-condition-displaying area 42 (step S303) and "1" indicating that the editing status information is valid is set (step S304), the consistency for loop setting is checked (step S305). Further, following the checking of the consistency for loop setting, the inter-step consistency is checked (step S306).

If the checked result of the consistency for loop setting is normal (step S307: "YES"), an icon indicating that the loop setting is normal is acquired (step S308). If the checked result of the consistency for loop setting is not normal (step S307: "NO"), an icon (third error icon) indicating that the loop setting is abnormal is acquired (step S309). After that, the loop icons acquired respectively in steps S308 and S309 are displayed in the loop-information-displaying area 415 (step S310).

If the checked result of the inter-step consistency is normal (step S311: "YES") and an icon (fourth error icon) indicating that the inter-step setting is abnormal is displayed, the icon is hidden in the consistency-determination-result-displaying area 414 (step S312), and the series of process ends.

If the checked result of the inter-step consistency is not normal (step S311: "NO"), the icon (fourth error icon) indicating that the inter-step setting is abnormal is displayed in the consistency-determination-result-displaying area 414 (step S313), and the series of process ends.

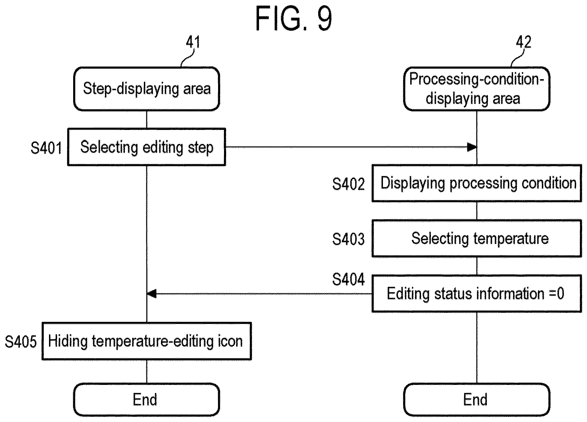

FIG. 9 is a sequence diagram illustrating an example of a process of hiding a temperature-editing icon when the editing status information is invalid. If an editing target step is selected in the step-displaying area 41 (step S401), processing conditions are displayed in the processing-condition-displaying area 42 (step S402). After that, if a temperature tab is selected in the processing-condition-displaying area 42 (step S403) and "0" indicating that the editing status information is invalid is set (step S404), a temperature-editing icon is hidden in the step-displaying area 41 (step S405), and the series of process ends.

In this way, according to the present embodiment, it is possible to perform control to switch a step selected in the step-displaying area to be displayed in a different manner compared to other steps when an editing operation for processing conditions is performed. As a result, it is possible to achieve an improvement in operational efficiency during recipe-editing.

In the above, the controlling apparatus and the substrate processing apparatus according to the embodiments have been described by way of example. The embodiments may refer to programs for causing a computer to execute the functions of the controlling apparatus and the substrate processing apparatus. The embodiments may also refer to a non-transitory recording medium readable by a computer storing these programs.

Moreover, the configurations of the controlling apparatus and the substrate processing apparatus described in the above embodiments are given by way of example and may be modified according to situations within the scope without departing from the gist.

Further, the process flow of the programs described in the above embodiments are also given by way of example, and unnecessary steps may be deleted, new steps may be added, or the process sequence may be changed within the scope without departing from the gist.

Further, in the above embodiments, a case where the process related to the embodiments is realized by a software configuration using a computer through the execution of a program has been described, but the embodiments are not limited to this. The embodiments may be realized, for example, by a hardware configuration or a combination of hardware and software configurations.

In the above embodiments, an example of forming a film using a batch-type substrate processing apparatus that processes a plurality of substrates at once has been described. The present disclosure is not limited to the above-described aspect, and for example, may be suitably applied to a case where a film is formed using a single-wafer type substrate processing apparatus that processes one or several substrates at once. Further, in the above-described aspect, an example of forming a film using a substrate processing apparatus with a hot wall type process furnace has been described. The present disclosure is not limited to the above-described aspect, and may be suitably applied to a case where a film is formed using a substrate processing apparatus with a cold wall type process furnace as well.

Even when using such a substrate processing apparatus, it is possible to perform each process using the same process procedures and processing conditions as in the above-described embodiments, and to achieve the same effects as in the above-described embodiments.

According to the present disclosure in some embodiments, it is possible to achieve an improvement in operational efficiency during recipe editing.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the disclosures. The accompanying claims and their equivalents are intended to cover such forms or modifications as would fall within the scope of the disclosures.

## Claims

1. A controlling apparatus comprising:
a recipe including a plurality of steps for which a processing condition for a substrate is defined;
a display capable of displaying at least one selected from information on the plurality of steps included in the recipe and information on the processing condition of at least one step selected from the plurality of steps;
an operator configured to perform an editing operation for the processing condition; and
a controller capable of controlling information on a step, among the plurality of steps, for which the editing operation for the processing condition is performed to be displayed in a different manner from information on a step, among the plurality of steps, for which the editing operation is not performed.

2. The controlling apparatus of Claim 1, wherein the display includes a step-displaying area that displays information on the plurality of steps and a processing-condition-displaying area that displays the processing condition, and is configured to display the step-displaying area and the processing-condition-displaying area side by side on a screen.

3. The controlling apparatus of Claim 1, wherein the displaying of the information on the step for which the editing operation for the processing condition is performed includes display of a first icon indicating that the editing operation is performed in the selected step.

4. The controlling apparatus of Claim 3, wherein the processing condition includes at least one setting item selected from the group of temperature, gas flow rate, pressure, and transfer mechanism, and
wherein the operator enables an editing operation for the at least one setting item.

5. The controlling apparatus of Claim 4, wherein the display includes a step-displaying area that displays information on the plurality of steps and a processing-condition-displaying area that displays the processing condition, and
wherein the step-displaying area displays the first icon only for the edited at least one setting item when the at least one setting item for the selected step is edited.

6. The controlling apparatus of Claim 5, wherein the first icon is different for each type of the at least one setting item.

7. The controlling apparatus of Claim 1, wherein the operator sets an execution condition for the selected step, and the display includes a step-execution-condition-displaying area that displays the execution condition for the step set by the operator, and
wherein the step-execution-condition-displaying area includes at least one of a jump-information-displaying area that displays jump information indicating transition from a step to another step and a loop-information-displaying area that displays loop information indicating repetition of the plurality of steps that are successive.

8. The controlling apparatus of Claim 7, wherein for the execution condition, when the jump-information-displaying area is selected and a step for a jump destination is specified, the display switches a jump start step that is a step where a jump starts and a jump end step that is a step where the jump ends to a different display compared to the other step.

9. The controlling apparatus of Claim 7, wherein for the execution condition, when the loop-information-displaying area is selected and a step for a loop destination is specified, the display switches a loop start step that is a step where a loop starts and a loop end step that is a step where the loop ends to be displayed in a different manner compared to the other step.

10. The controlling apparatus of Claim 9, wherein the display displays, as a third icon, a loop start icon that is an icon indicating the loop start step and a loop end icon that is an icon indicating the loop end step, the loop start icon and loop end icon being different from each other.

11. The controlling apparatus of Claim 1, wherein the controller includes a determiner that determines consistency of at least one step of the plurality of steps, and
wherein the determiner determines at least one of consistency in the step for which is edited for the processing condition and consistency with steps before and after the edited step.

12. The controlling apparatus of Claim 11, wherein the controller controls the display to display a fourth icon according to a result determined by the determiner if the result determined by the determiner is mismatch.

13. A substrate processing apparatus comprising:
the controlling apparatus of Claim 1; and
a process container that processes the substrate according to the recipe.

14. A method of manufacturing a semiconductor device, the method comprising:
displaying a plurality of steps included in a recipe, for which a processing condition for a substrate is defined;
displaying the processing condition of at least one step selected from the plurality of steps;
performing an editing operation for the processing condition;
switching the selected step to be displayed in a different manner compared to a step for which the editing operation is not performed, when the editing operation for the processing condition of the selected step is performed; and
processing the substrate according to the recipe.

15. A program that causes, by a computer, a substrate processing apparatus to perform a process comprising:
displaying a plurality of steps included in a recipe, for which a processing condition for a substrate is defined;
displaying the processing condition of at least one step selected from the plurality of steps;
performing an editing operation for the processing condition;
switching the selected step to be displayed in a different manner compared to a step for which the editing operation is not performed, when the editing operation for the processing condition of the selected step is performed; and
processing the substrate according to the recipe.
